# EUROPEAN PATENT APPLICATION

(11) **EP 2 028 917 A2**
(43) Date of publication of application: **25.02.2009**
(21) Application number: 08162548.5
(22) Date of filing: 18.08.2008
(51) Int. Cl.: H05K 7/14

(54) **Vibration isolators for printed wiring boards**

(30) Priority: 21.08.2007 US 842456
(71) Applicant: Honeywell International Inc., Morristown, NJ 07962 (US)
(72) Inventor: Platt, William P., Forest Lake, MN 55025 (US); Boyd, Larren E., Golden Valley, MN 55427 (US); Turner, James P., St. Paul, MN 55116 (US); Armon, Lori J., Minneapolis, MN 55406 (US)
(74) Representative: Buckley, Guy Julian

(57) **Abstract**

A vibration isolator device for printed wiring boards. An example vibration isolator device includes a solder tab with an clastomcric material that is adhesively attached to a first side of the solder tab. The second side of the solder tab is attached to a printed wiring board. Solder paste is pre-applied to the printed wiring board prior to attachment of the vibration isolator device. The solder tab has a U-shaped cross section.

## Description

### BACKGROUND OF THE INVENTION

Present vibration acoustic isolators for printed wiring boards (PWB) are typically too large to fit on small PWB's used with micro-electro mechanical systems (MEMS) gyros. Typical devices that are used for isolating PWB's from undesired shocks are used between a package that includes the PWB's and the device to which the package is mounted. This method is costly because of the number of steps for installation. Also, these isolators are large with respect to small printed wiring boards, thus occupying valuable space.

### SUMMARY OF THE INVENTION

The present invention provides a vibration isolator device for printed wiring boards. An example vibration isolator device includes a solder tab with an elastomeric material that is adhesively attached to a first side of the solder tab. The second side of the solder tab is attached to a printed wiring board.

In one aspect of the present invention, solder paste is pre-applied to the printed wiring board prior to attachment of the vibration isolator device.

In another aspect of the present invention, the solder tab has a U-shaped cross section.

In still another aspect of the present invention, a receiving groove is located on a side of a printed wiring board. The groove receives at least a portion of the elastomeric material.

In yet another aspect of the present invention, the tab is a solderable material. The solder tab and elastomeric material are extracted from a linear extension of a plurality of solder tabs with attached elastomeric material.

### BRIEF DESCRIPTION OF THE DRAWINGS

FIGURES 1A and 1B illustrate front and side views of examples formed in accordance with the embodiment of the present invention;

FIGURE 2 illustrates a side cross-sectional view of an alternate embodiment formed in accordance with the present invention;

FIGURES 3-5 illustrate perspective views of an example implementation of the present invention; and

FIGURE 6 illustrates a view of an alternate embodiment of the present invention.

### DETAILED DESCRIPTION OF THE PREFERRED EMBODIMENT

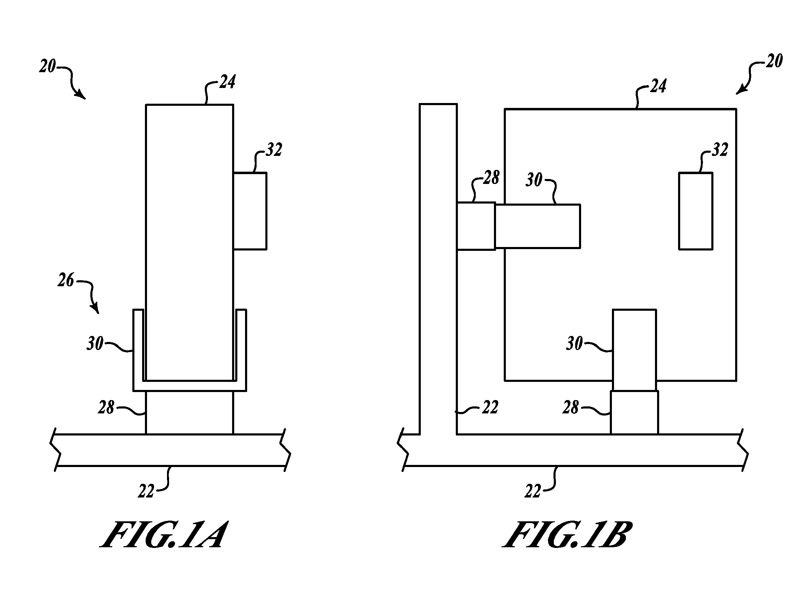

FIGURES 1A and 1B illustrate side and front views of an example system 20 for isolating a printed wiring board (PWB) 24 from base and side walls 22a, b of a chassis or package (not shown). In this example, the PWB 24 is a fibrous or other similar material board that includes predefined circuit traces and includes mounts for receiving a number of different electronic components, such as a micro-electro mechanical system (MEMS) sensor 32.

The system 20 includes one or more isolators 26 that attach to the PWB 24 and provide isolation between the PWB 24 and the base and walls 22 of the package. The isolator 26 includes a solder tab 30 and an elastic isolator 28. The isolators 26 may be formed in an elongated form supplied in a flexible reel. An operator cuts a portion of the isolator 26 from the reel for use prior to attachment to the PWB 24. In one embodiment, the solder tab 30 is brass or is a metal or other alloy having similar properties to brass for solderability. The elastic isolator 28 is a silicone based isolator or is a material having similar properties such as rubber cement. The elastic isolator 28 is adhesively attached to one side or a portion of one side of the solder tab 30. The elastic isolator 28 is attached using an adhesive or is directly attached to the solder tab 30 because it has adhesive properties.

The solder tab 30 is sized based on the thickness of the PWB 24 before it is attached to the PWB 24. The solder tab 44 is preformed into a cross sectional U-shape that is sized to be received by the PWB 24. Before the isolator 26 is attached to the PWB 24, a mask is applied to the PWB 24 based on the location where the solder tab 30 will come in contact with the PWB 24. Then, a solder paste, for example, lead Pb, tinSn, an oil-based resin or comparable adhesive material, is applied to the PWB 24 based on the applied mask. Then, the mask is removed after the application of the solder paste and the isolator 26 is placed onto the desired location on the PWB 24 either manually or by a pick and place automated machine (not shown). If the solder paste requires heat curing, then after the isolator 26 is attached to the PWB 24 and possibly after any electronic components are attached to the PWB 24, a heating process (e.g. IR reflow, wave process, or other known techniques) is applied to all, thereby simultaneously curing the electronic components and the isolators 26 to the PWB 24.

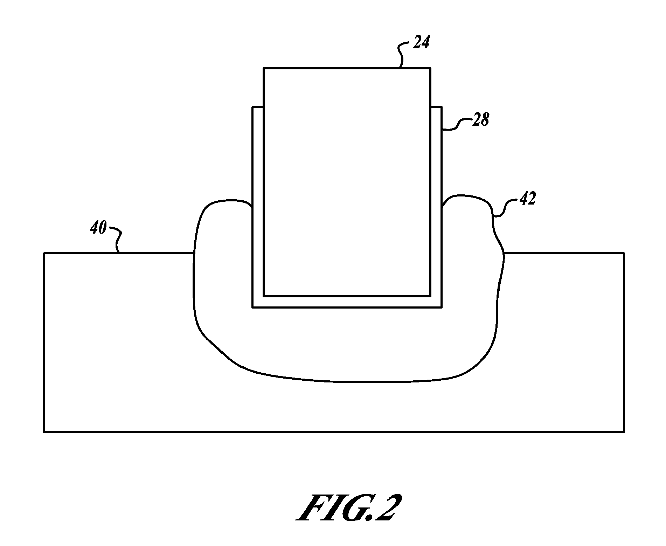

FIGURE 2 illustrates a cross-sectional view of an isolator 40 that is attached to the PWB 24. The isolator 40 includes an elastic isolator 42 and a solder tab 44. In this example, a chassis or package wall or base 46 includes a groove or cavity 48 that is designed to receive the elastic isolator 42 of the isolator 40. The groove or cavity 48 can be designed such that the base of the PWB 24 extends below the plans of the surface of the wall 46. The solder tab 44 is similar to the solder tab 30 of FIGURE 1A, 1B. The elastic isolator 42 attached thereto is similar to the isolator 28 of FIGURES 1A and 1B, except that the elastic isolator 42 is attached to 3 outside surfaces of the u-shaped solder tab 44.

In one embodiment, the solder tab 30 of the isolator 26 is cut from the flat tape reel with a thickness greater than the thickness of the PWB 24. When the isolator 26 is to be attached to the PWB 24, a manual or automatic device bends the solder tab 30 around the edges of the PWB 24 in order to form a cross-sectional U-shape.

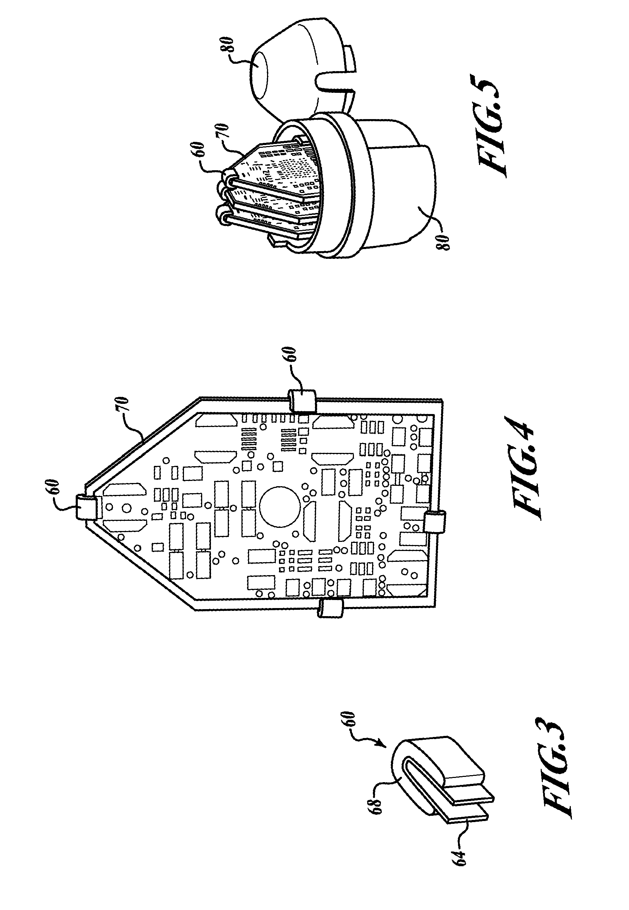

FIGURE 3 illustrates a perspective view of isolator 60 having a U-shaped cross-sectioned solder tab 64 covered on its outside surface with an elastic isolator 68.

FIGURES 4 and 5 illustrate perspective views of a PWB 70 having four isolators 60 attached to an outer edge of the PWB 70. A package 80 is designed to receive one or more PWB's 70 with the attached isolators 60. The isolators 60 come in contact with interior walls of the package 80 in order to provide adequate shock or vibration protection for the PWB 70. Also, the isolators 60 may come in contact with isolators 60 on each other for adjacent PWB 70 in order to provide adequate separation between the PWB 70.

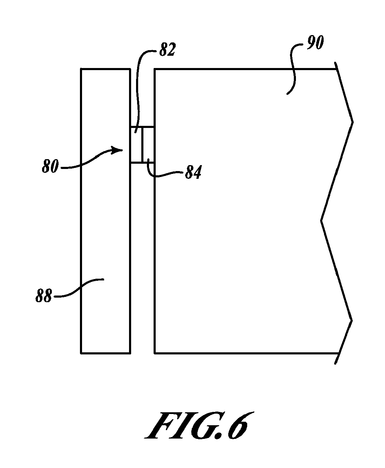

As shown in FIGURE 6, an isolator 80 includes a flat solder tab 82 that attaches to a PWB 88 at a front or back surface of the PWB 88. An elastomeric material 84 that is attached to one side of the solder tab 82 protects the PWB 88 from shock from a package wall 90.

In the present invention, the isolators can be moved on the board in relation to the board's center of gravity. This adjustability allows "tuning" of the board to eliminate vibration resonance nodes and improve on isolation performance parameters such as VRE (vibration rectification error).

While the preferred embodiment of the invention has been illustrated and described, as noted above, many changes can be made without departing from the spirit and scope of the invention. For example, the isolator described above may be for providing vibration isolation for a variety of support structures other than printed wiring boards. Accordingly, the scope of the invention is not limited by the disclosure of the preferred embodiment. Instead, the invention should be determined entirely by reference to the claims that follow.

## Claims

1. An isolator apparatus comprising:
a solder tab (30); and
an elastomeric material (28) adhesively attached to a first side of the solder tab,
wherein a second side of the solder tab is attached to a support structure.

2. The apparatus of Claim 1, further comprising a solder material positioned between the solder tab and the support structure.

3. The apparatus of Claim 1, wherein the solder tab has a U-shaped cross section.

4. The apparatus of Claim 1, wherein the solder tab is a solderable material.

5. The apparatus of Claim 1, wherein the solder tab and elastomeric material are extracted from a linear extension of a plurality of solder tabs with attached elastomeric material.

6. The apparatus of Claim 5, wherein the linear extension of a plurality of solder tabs with attached elastomeric material is provided on a reel.

7. The apparatus of Claim 5, wherein the solder tabs are placed in desired positions on the support structure using an automated pick and place machine.

8. The apparatus of Claim 1, wherein the support structure is a printed wiring board.
